# EUROPEAN PATENT SPECIFICATION

(11) **EP 3 016 489 B1**
(45) Date of publication and mention of the grant of the patent: **21.08.2019**
(21) Application number: 13887977.0
(22) Date of filing: 24.06.2013
(51) Int. Cl.: H05K 13/04, H01L 21/67, H01L 23/00

(54) **COMPONENT MOUNTING SYSTEM AND COMPONENT MOUNTING METHOD**
MASCHINE ZUR MONTAGE VON KOMPONENTEN UND VERFAHREN ZUR MONTAGE VON KOMPONENTEN
SYSTÈME DE MONTAGE DE COMPOSANTS ET PROCÉDÉ DE MONTAGE DE COMPOSANTS

(43) Date of publication of application: 04.05.2016
(73) Proprietor: FUJI Corporation, Chiryu Aichi (JP)
(72) Inventor: HOSHIKAWA, Kazumi, Chiryu, Aichi (JP)
(74) Representative: Grünecker Patent- und Rechtsanwälte PartG mbB
(86) International application number: PCT/JP2013/067228
(87) International publication number: WO 2014/207803

(56) References cited:
- JP-A- H0 456 200
- JP-A- H01 318 297
- JP-A- H05 198 983
- JP-A- 2004 214 453
- JP-A- 2013 026 537
- US-A1- 2009 002 006
- US-A1- 2011 302 776

## Description

### Technical Field

The present invention relates to a component mounting system and component method in which a die supply device that supplies dies formed by dicing a wafer attached to a dicing sheet and multiple feeders that supply passive components which are to be combined with the dies are both loaded on a component mounter, wherein the dies and the passive components are mounted on a circuit board by the component mounter.

### Background Art

In recent years, as disclosed in patent literature 1 (JP-A-2010-129949), there are items in which a die supply device that supplies dies formed by dicing a wafer attached to a dicing sheet is set onto a component mounter, and wherein the dies supplied from the die supply device are mounted on a circuit board by the component mounter.

Patent literature 2 discloses a manufacturing method of a semiconductor device that inter alia comprises the steps of generating a mapping data set based on an electrical test on a plurality of electronic components on a wafer, forming bumps on the plurality of electronic components with reference to the mapping data set, dicing the wafer to separate the plurality of electronic components and mounting the components. The mapping data set includes position information of the respective electronic components, and category information representing categories of the respective electronic components based on the electrical test result. Depending on the category of each electronic component, the electronic components are bumped in various bump layouts, wherein bumped pads on the electronic component are connected to pads on the circuit board and unbumped pads on the electronic component are not connected to the circuit board.

Patent literature 3 provides an electronic circuit assembling process, wherein electronic circuit components including at least one of a plurality of different-property components having respective different electrical properties are mounted onto a circuit board. The assembling process inter alia comprises obtaining different-property-component-related information, such as electrical property of the different-property components and different-property-component supply positions, mounting the electronic circuit component including the different property component onto the circuit board, based on the different-property-component supply position information, and providing the circuit board with the property-related information of the different-property component mounted on the circuit board.

### Citation List

### Patent Literature

Patent Literature 1: JP-A-2010-129949
Patent Literature 2: US 2009/002006 A1
Patent Literature 3: US 2011/302776 A1

### Summary of Invention

### Technical Problem

However, dies are active components (for example, transistors, diodes, LEDs, ICs, operational amplifiers, and so on), and there are cases in which variance exists in their electrical characteristics. Because dies with a small variance in characteristics are more expensive due to higher manufacturing costs, cheaper dies with a large variance in characteristics are sometimes used in order to lower costs. Generally, because the characteristics of dies can be adjusted by combining the die with a passive component (for example, a resistor, coil, capacitor, and so on), it is possible to absorb variance in a characteristic of a die by mounting the die in combination with a passive component with an optimal characteristic for each characteristic of die to be mounted on a circuit board.

Conventionally, when using dies with a large variance in a characteristic, the characteristic of each die of the wafer attached to the dicing sheet is measured in advance, each die is peeled from the dicing sheet, the dies are ranked by the characteristic measured value, taping work to house the dies in component supply tape by each rank is performed, component supply tape of each rank is set on separate feeders, and those feeders are set on a component mounter so as to supply the dies to the component mounter.

However, with this method, an operator must perform time-consuming work of peeling each die from the dicing sheet, ranking the dies, and housing the dies in component supply tape in advance, which is extremely troublesome. Also, there are cases in which this ranking and taping work is performed by the die manufacturer/vendor, but in this case the price of the dies increases.

Thus, an object of the present invention is to solve the above problems by providing a component mounting system that renders unnecessary time-consuming ranking and taping work by using a component mounter to mount a die supplied from a die supply device on a circuit board in combination with a passive component with an appropriate characteristic for the die.

### Solution to Problem

To solve the above problem, the present invention is a component mounting system and component mounting method comprising: a component mounter loaded with both a die supply device that supplies dies formed by dicing a wafer attached to a dicing sheet, and multiple feeders that supply a passive component to be combined with the die; and a means for acquiring wafer map data which ranks each die of the wafer by a characteristic, and passive component combination data that specifies a combination passive component with an appropriate characteristic for each rank of die from multiple passive components with a different characteristic; wherein the component mounter mounts the die and the passive component on a circuit board, wherein the multiple feeders supply the multiple passive components with a different characteristic to the component mounter; wherein the die supply device supplies each die of the wafer sequentially to the component mounter; and wherein the component mounter mounts the passive component to be combined with the die supplied from the die supply device on the circuit board by selecting the passive component from the multiple passive components with a different characteristic based on the wafer map data and the passive component combination data.

In this case, because the component mounter knows the characteristic rank of each die by referring to the wafer map data, and knows the passive component with an appropriate characteristic to be combined with each die by referring to the passive component combination data, the component mounter can select a passive component with the optimal characteristic to be combined with a die supplied from the die supply device from the multiple passive components with a different characteristic, and mount the passive component on the circuit board such that variance in a characteristic of each die is absorbed. Thus, the time-consuming work of ranking and taping is no longer necessary, and productivity is improved.

Note that, by referring to the wafer map data, it is possible to select only dies with the same rank among each die on the wafer and supply only those dies to the component mounter; however, dies of a different rank are arranged on the wafer in a random manner, and in order to select only dies with the same rank and supply only those dies to the component mounter, it is necessary to pick up dies which are scattered here and there on the wafer. However, when picking up dies which are scattered here and there on the wafer, the interval between the dies to be picked up becomes longer, which means that the influence of the positional deviation at which the dies are arranged becomes larger, making pickup easier to fail. In contrast, if supplying each die from the wafer to the mounter sequentially as in the present invention, the influence of the positional deviation at which the dies are arranged becomes smaller, which enables the prevention of pickup failure.

With the present invention, when mounting multiple dies on one circuit board, mounting may be performed by classifying the multiple dies into two or more groups, and mounting dies of the same rank in a line for each group. By doing this, a characteristic variance of dies of each group can be reduced, for example, in a case in which the dies are LEDs, the variance in LED brightness and hue due to variance in a characteristic of the LEDs of each group can be reduced, thus the brightness and hue of LEDs of each group can be made uniform.

Also, with the present invention, one passive component may be mounted in combination with the multiple dies of the same rank belonging to a group. By doing this, the quantity of passive components mounted on the circuit board can be drastically reduced, thereby improving productivity and cost-effectiveness.

Also, data indicating whether each die on the wafer is good or defective may be included in the wafer map data such that the die supply device may skip dies which are determined to be defective based on the wafer map data and only supply dies which are determined to be good to the component mounter. By doing this, the production of boards mounted with defective dies is prevented.

The present invention may be provided with a data creation device that creates passive component combination data, and the data creation device may transmit created passive component combination data to the component mounter. By doing this, passive component combination data can be created by the data creation device and there is no need to create the passive component combination data externally.

### Brief Description of Drawings

Fig. 1 is a plan view showing an embodiment of the present invention in a state with a die supply device set in a component mounter.
Fig. 2 is a perspective view showing the die supply device set in the component mounter.
Fig. 3 is a side view showing the positional relationship between a mounting head of the component mounter and the die supply device set in the component mounter.
Fig. 4 is a side view showing the height positional relationship between the mounting head of the component mounter and the supply head of the die supply device when the stage of the die supply device is raised.
Fig. 5 is a side view showing the height positional relationship between the mounting head of the component mounter and the supply head of the die supply device when the stage of the die supply device is lowered.
Fig. 6 is a side view showing a state in which a die on a wafer pallet on the stage of the die supply device is to be picked up by the supply head.
Fig. 7 is a side view showing a state in which a die on the inverted supply head is to be picked up by the mounting head of the component mounting machine.
Fig. 8 is a side view showing a state in which a die on a wafer pallet on the stage of the die supply device is to be picked up directly by the mounting head of the component mounter.
Fig. 9 is an external perspective view of the supply head of the die supply device as seen obliquely from below.
Fig. 10 is an external perspective view showing a state in which a wafer pallet is not drawn onto the stage from the magazine of the die supply device as seen obliquely from above.
Fig. 11 is an external perspective view showing a state in which a wafer pallet is drawn onto the stage from the magazine of the die supply device as seen obliquely from above.
Fig. 12 shows an example of die rank data and passive component combination data.
Fig. 13 shows an example of wafer map data.
Fig. 14 shows a mounting example (1) of a circuit board onto which dies and passive components have been mounted in combination.
Fig. 15 shows a mounting example (2) of a circuit board onto which dies and passive components have been mounted in combination.

### Description of Embodiment

An embodiment of the invention is described below.

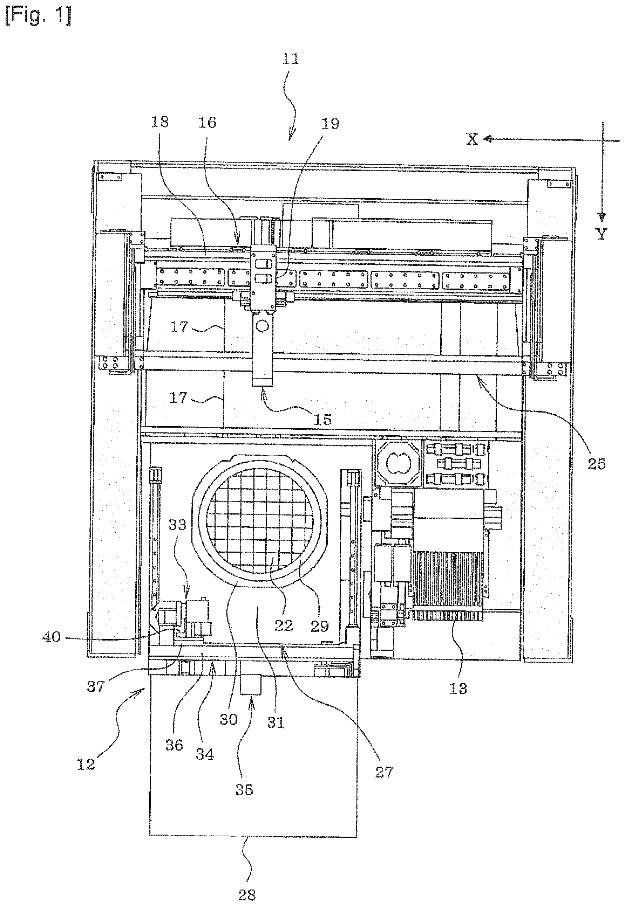

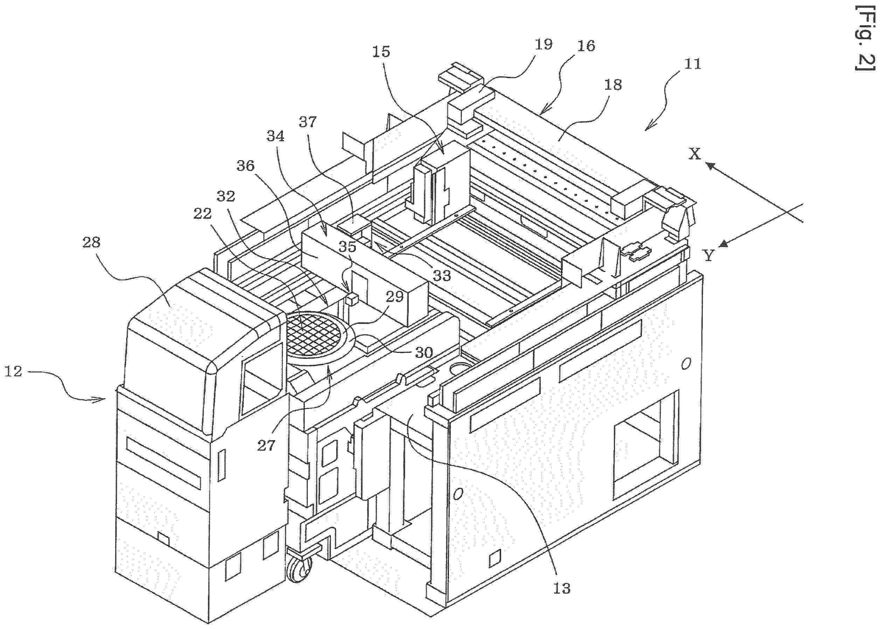

As shown in fig. 1 and fig. 2, die supply device 12 is detachably set in component mounter 11. In component mounter 11, feeder setting table 13 is provided adjacent to a set position of die supply device 12, and a feeder (not shown) such as a tape feeder is detachably set on feeder setting table 13. The feeder set on feeder setting table 13 is not limited to a tape feeder and may be a bulk feeder, a stick feeder, and the like, and multiple types of the feeders may be set on feeder setting table 13.

Component mounter 11 is provided with an XY moving mechanism 16 (XY robot) that moves mounting head 15 in XY-directions (right-left and front-rear directions). XY moving mechanism 16 includes Y slide 18 that slides in a Y-direction (a direction perpendicular to a conveyance direction of circuit board 17) and X slide 19 which is slidably supported on Y slide 18 in an X-direction (the conveyance direction of circuit board 17); mounting head 15 is supported on X slide 19.

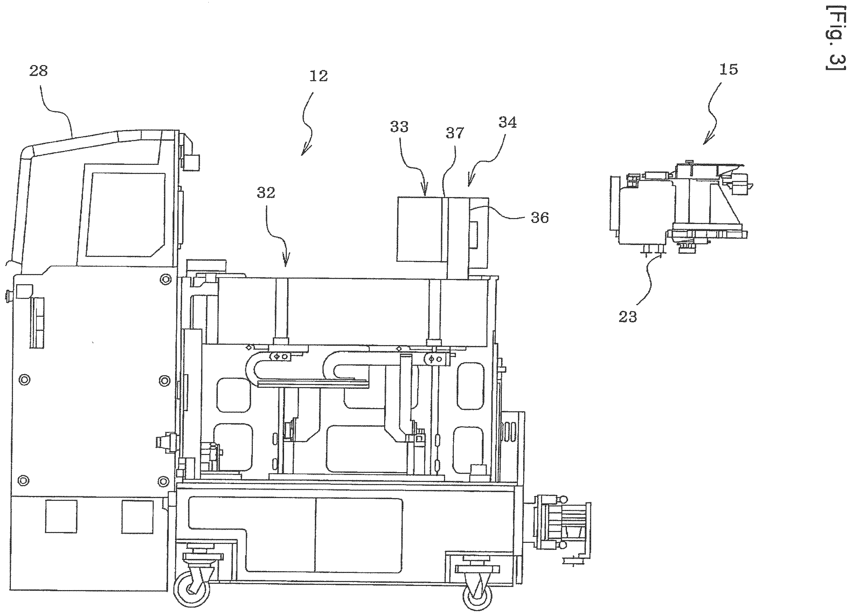

Mounting head 15 of component mounter 11 is provided with one or multiple suction nozzles 23 (refer to figs. 3 to 8) that pick up a die 22 supplied from die supply device 12 or an electronic component (hereinafter referred to as a "feeder component") supplied from a feeder, a mark camera (not shown) that images an imaging target such as a fiducial mark of circuit board 17 from above, and the like.

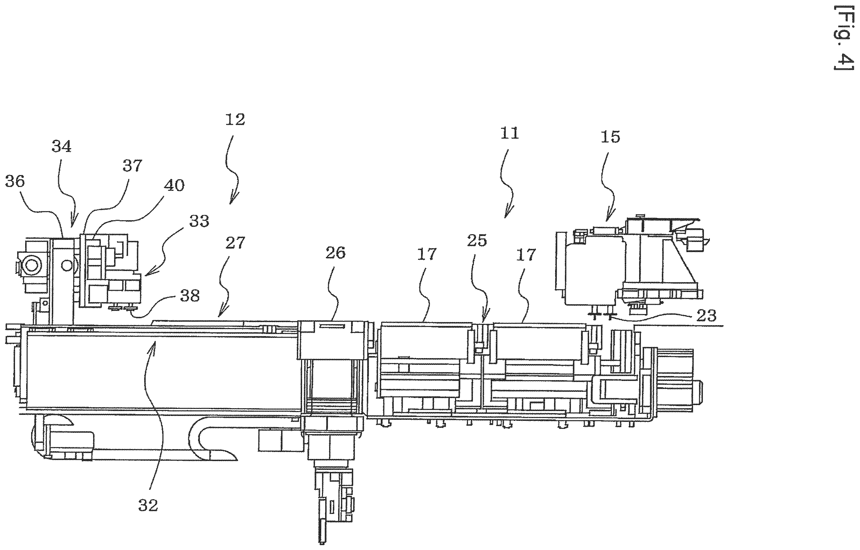

Component mounter 11 is provided with two conveyors 25 which convey circuit board 17 lined up next to each other; component camera 26 (refer to figs. 4 to 8) that images die 22 or the feeder component which has been picked up by suction nozzle 23 of the mounting head 15 from below is provided facing upward at a position between conveyors 25 and die supply device 12 (or the feeder).

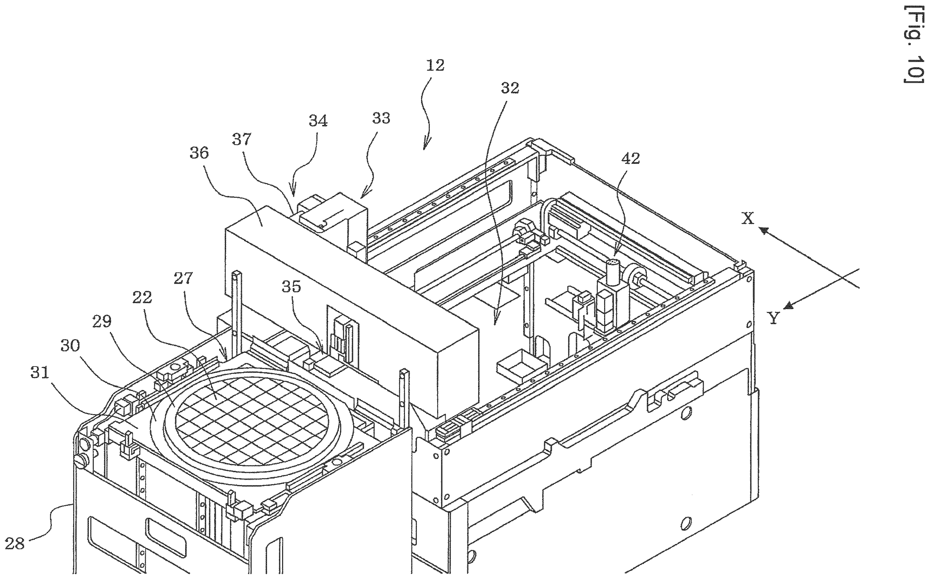

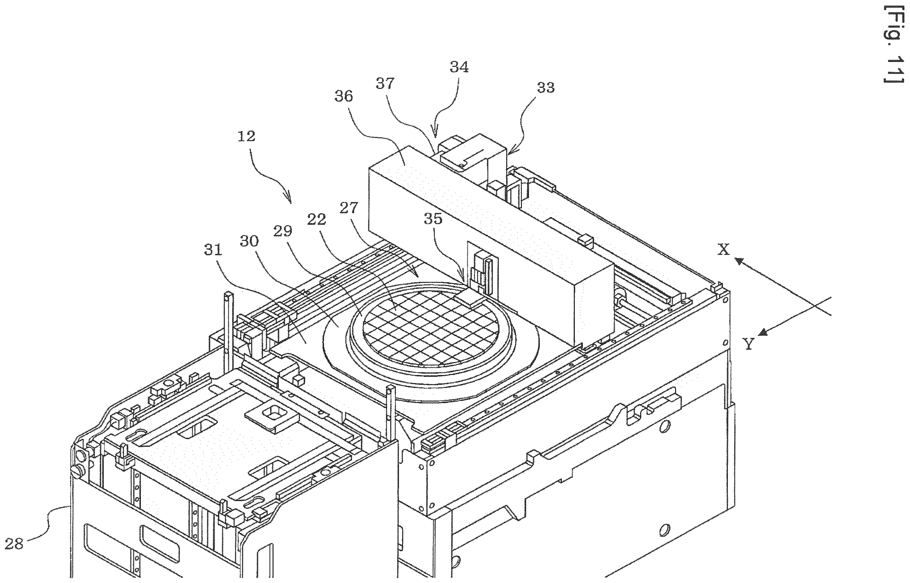

Meanwhile, die supply device 12 is provided with magazine 28 which houses wafer pallets 27 at multiple levels. As shown in fig. 10 and fig. 11, wafer pallet 27 is configured such that elastic dicing sheet 29 attached with a wafer diced so as to be divided into multiple dies 22 is mounted in an expanded state on dicing frame 30 that has a circular opening portion, and dicing frame 30 is attached to pallet main body 31 by screw clamps or the like. Die supply die 12 is provided with drawing-out mechanism 35 which draws out wafer pallet 27 from magazine 28 onto stage 32.

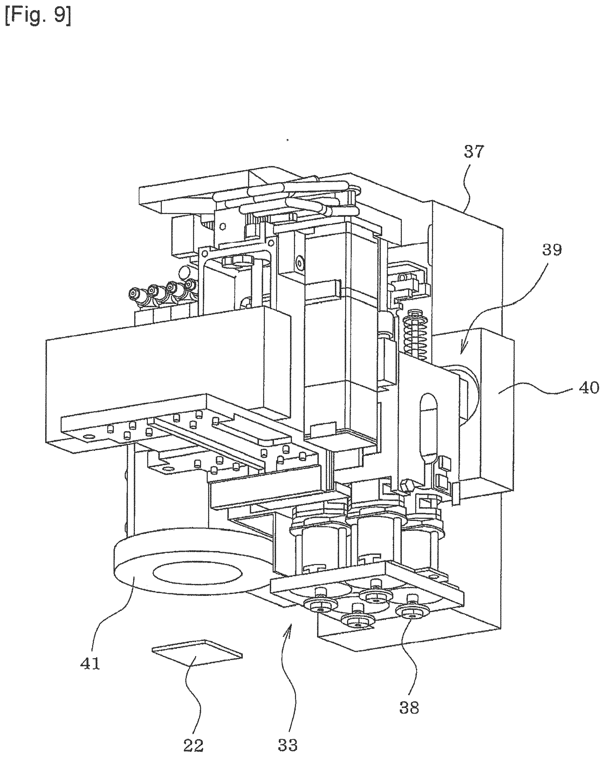

Also, die supply device 12 is provided with head moving mechanism 34 (XY robot) that moves supply head 33 in the XY-directions (the right-left and front-rear directions). Head moving mechanism 34 includes Y slide 36 that slides in the Y-direction, and X slide 37 that is supported on Y slide 36 so as to be slidable in the X-direction; supply head 33 is detachably held by head holding unit 40 that is provided on X slide 37; one or multiple suction nozzles 38 (refer to fig. 9) are held by supply head 33 so as to be vertically movable. Supply head 33 of die supply device 12 is used when die 22 is attached on dicing sheet 29 of wafer pallet 27 with the mounting surface facing upward and is configured such that, after die 22 has been picked up by suction nozzle 38 of the supply head 33, the supply head 33 is inverted by inverting mechanism 39 (refer to fig. 9), thereby inverting die 22 as to be picked up by suction nozzle 23 of mounting head 15 of component mounter 11.

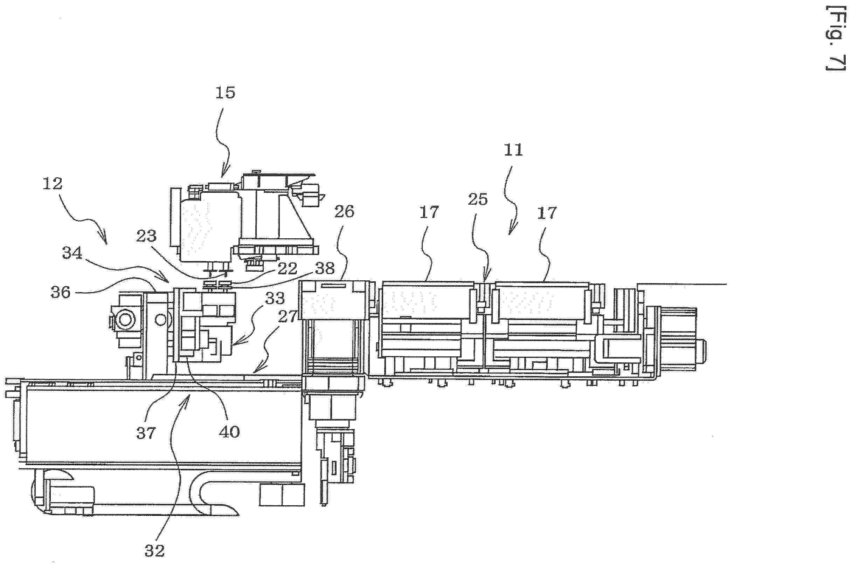

In this case, since the height position of die 22 on the inverted supply head 33 must be adjusted to the pickup height position of mounting head 15 of component mounter 11, an up-down moving mechanism (not shown) which moves supply head 33 of die supply device 12 up and down integrally with stage 32 on which wafer pallet 27 is set is provided, and in cases in which die 22 is inverted and then mounted on circuit board 17, as shown in fig. 7, die 22 on inverted supply head 33 is picked up by mounting 15 of component mounter 11 at a position in which supply head 33 and stage 32 have been lowered by the up-down moving mechanism.

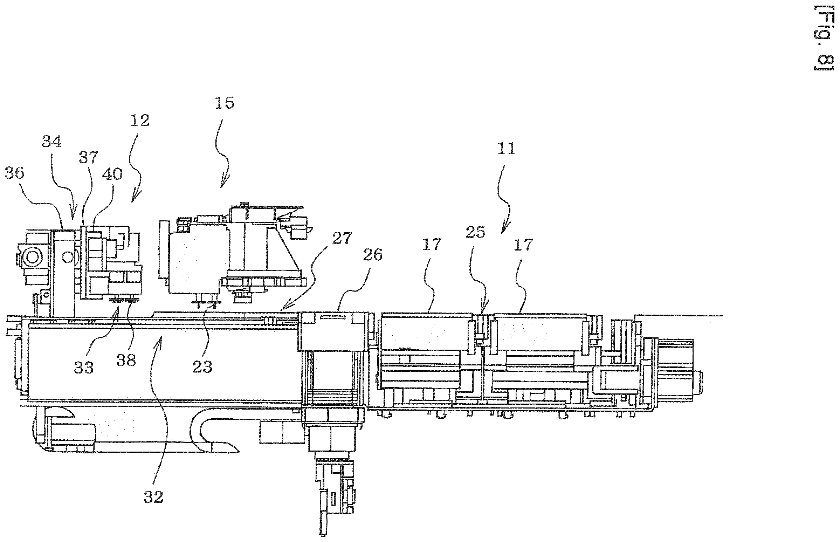

Meanwhile, when die 22 is attached on dicing sheet 29 of wafer pallet 27 with the mounting surface facing downward, die 22 is mounted on circuit board 17 without being inverted. In this case, as shown in fig. 8, die 22 of wafer pallet 27 on stage 32 is picked up by suction nozzle 23 of mounting head 15 of the component mounter 11 at a position in which supply head 33 and stage 32 have been raised by the up-down moving mechanism.

Supply head 33 of die supply device 12 is provided with camera 41 (refer to fig. 9) that images die 22 before the die 22 is picked up by suction nozzle 38 of supply head 33; an image captured by camera 41 is processed to recognize the position of die 22, and then die 22 is picked up by suction nozzle 38 of supply head 33. Further, when recognizing the position of die 22 based on processing results of the image captured by camera 41, it is determined whether the die is defective based on the wafer map data described below; in a case in which the die 22 is determined to be defective, the defective die 22 is not picked up and the process proceeds to image processing of an adjacent die 22.

Also, die supply device 12 is provided with pushup mechanism 42 (refer to fig. 10) which pushes up a portion of dicing sheet 29 which is to be picked up by suction nozzle 38 from below when die 22 is picked up by suction nozzle 38 of supply head 33. Pushup mechanism 42 moves up and down in association with the up-down movement of stage 32.

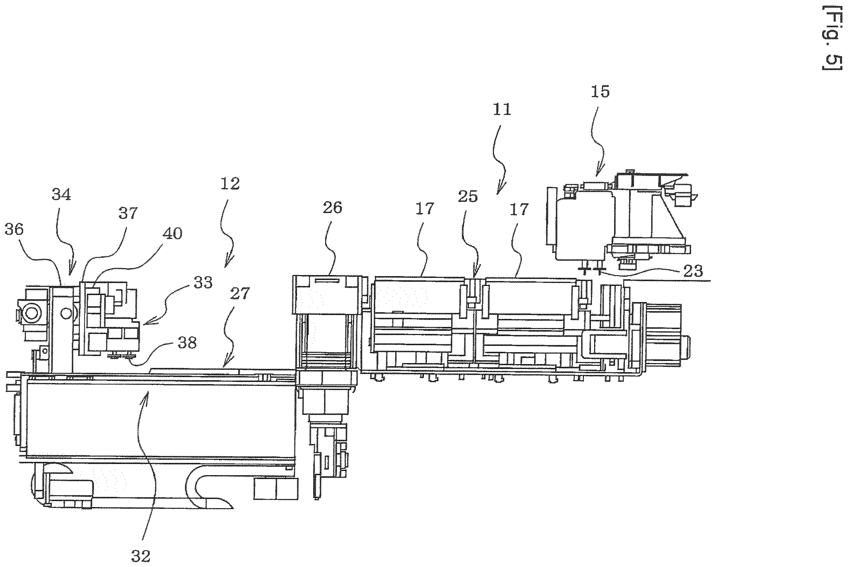

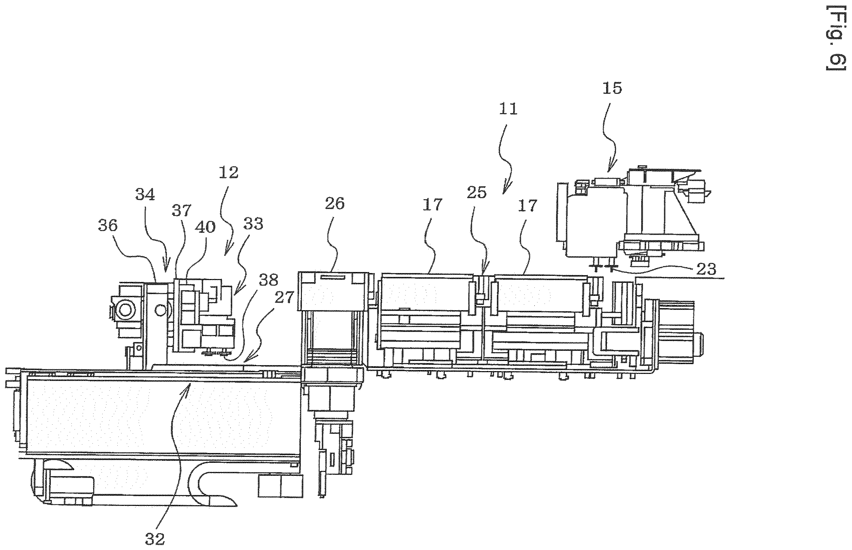

While component mounter 11 is operating, a control device (not shown) controls operations of component mounter 11, die supply device 12, and the feeder in accordance with a production job (a production program) such that any one of die 22 supplied from die supply device 12 and the feeder component supplied from the feeder is picked up and mounted on circuit board 17. Here, in a case in which die 22 is inverted and then mounted on circuit board 17, as shown in fig. 5, supply head 33 of die supply device 12 and stage 32 are lowered, and as shown in fig. 6, supply head 33 is moved to be positioned over wafer pallet 27, then, before the die 22 is picked up by supply head 33, camera 41 images the die 22 so as to recognize the position of the die 22, then the die 22 is picked up by suction nozzle 38 of supply head 33. Next, as shown in fig. 7, supply head 33 of die supply device 12 is inverted such that die 22 held by suction nozzle 38 is inverted, mounting head 15 of component mounter 11 is moved to be positioned over supply head 33, then, the die 22 on suction nozzle 38 of supply head 33 is picked up by suction nozzle 23 of mounting head 15 and is mounted on circuit board 17.

Note that, dies are active components (for example, transistors, diodes, LEDs, ICs, operational amplifiers, and so on), and there are cases in which variance exists in their electrical characteristics (for example, voltage V, capacitance C, inductance L, frequency F, and so on). Because producing dies with a small variance in characteristics leads to higher production costs, there are cases in which cheaper dies which have a large variance in a characteristic are used, in order to lower costs. Generally, because a characteristic of dies can be adjusted by combining the die with a passive component (for example, a resistor, coil, capacitor, and so on), it is possible to absorb the variance in the characteristic of a die to mounted on circuit board 17 by mounting the die in combination with a passive component with an appropriate characteristic for each characteristic of die to be mounted on a circuit board.

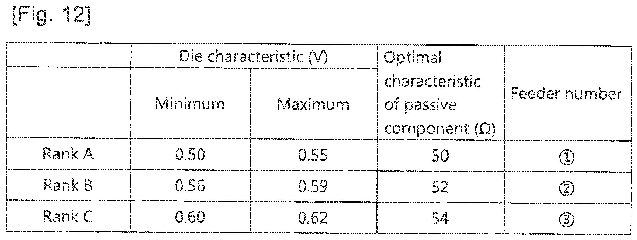

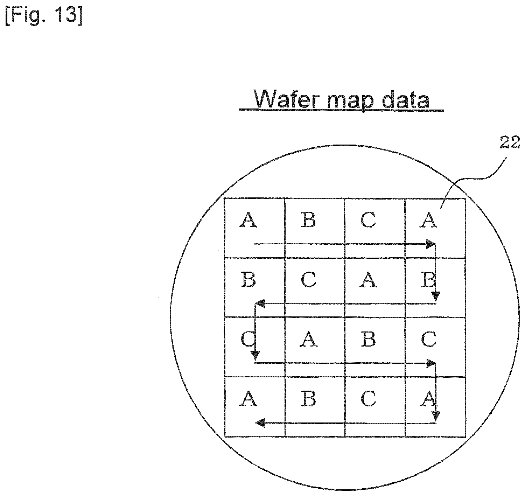

For this, in the present embodiment, as shown in fig. 12 and fig. 13, data which ranks a characteristic (for example, voltage V, capacitance C, inductance L, frequency F, and so on) of each die on a wafer is added to wafer map data that indicates the coordinates position of each die on the wafer and whether each die is good or defective. In the example of fig. 12 and fig. 13, a characteristic of a die is classified into three types, rank A, rank B, and rank C. For example, rank A signifies 0.50 to 0.55 (V), rank B signifies 0.56 to 0.59 (V), and rank C signifies 0.60 to 0.62. Further, passive component combination data that specifies a combination passive component with the optimum characteristic for each rank of die from multiple passive components with a different characteristic is also added. Passive components with the optimal characteristic to be combined with a die of each rank A, B, and C are respectively 50 (Ω), 52 (Ω), and 54 (Ω) passive components. Feeders numbering 1 to 3 that supply each characteristic passive component are set in the passive component combination data.

Wafer map data and passive component combination data created by the die manufacturer/vendor may be used, or a user of component mounter 11 may create wafer map data and passive component combination data using a control device of component mounter 11, a production management computer of a component mounting line in which the component mounter 11 is arranged, or a personal computer which is able to communicate with these, as a data creation device, and may transmit the data to component mounter 11 and die supply device 12. In this case, among the wafer map data, for data indicating coordinates of a die and whether a die is good or defective, data supplied from the die manufacturer/vendor may be used, and rank data of each die may be added.

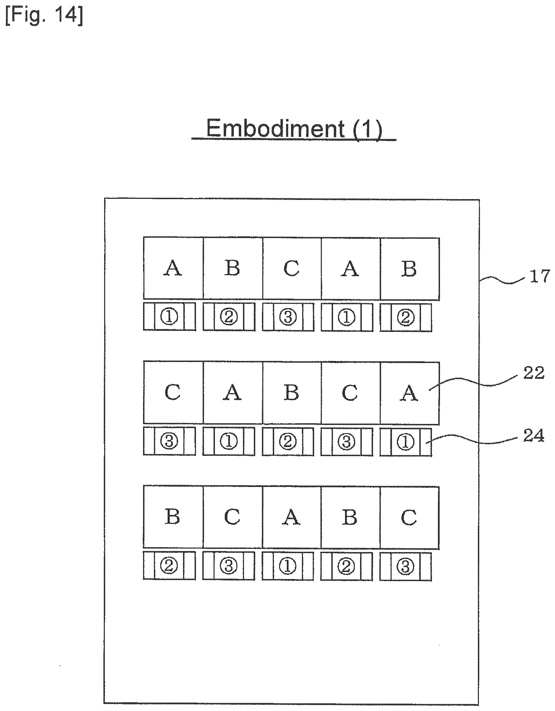

When mounting dies 22 on circuit board 17 using component mounter 11, as well as die supply device 12 being set on component mounter 11, multiple feeders that supply a passive component 24 (refer to fig. 14) with an optimal characteristic to be combined with die 22 of each rank supplied using the die supply device 12 are set on feeder setting table 13 of component mounter 11. Before starting production, wafer map data and passive component combination data are transmitted to (or data is registered with) component mounter 11 and die supply device 12. After starting production, as shown by the arrows in fig. 13, die supply device 12 supplies each die 22 of the wafer to component mounter 11 in the order that the dies 22 are arranged on the wafer, and transmits rank information of dies 22 that are supplied to component mounter 11. As shown in fig. 14, component mounter 11 selects passive component 24 with the optimal characteristic to be combined with die 22 supplied from die supply device 12 from the multiple passive components (multiple feeders) with a different characteristic based on the rank information of the die 22 and the passive component combination data, and mounts the passive component 24 on circuit board 17 such that variance in a characteristic of each die 22 is absorbed. In this case, for a die 22 with rank A, passive component 24 of 50 (Ω) supplied from feeder number 1 is mounted; for a die 22 with rank B, passive component 24 of 52 (Ω) supplied from feeder number 2 is mounted; and for a die 22 with rank C, passive component 24 of 54 (Ω) supplied from feeder number 3 is mounted.

Because, in addition to rank information of each die 22 of the wafer, data indicating whether each die 22 is good or defective is included in the wafer map data, die supply device 12, based on the wafer map data, skips dies 22 determined to be defective and only supplies dies 22 determined to be good to component mounter 11. Thus, the production of boards mounted with defective dies is prevented.

With the embodiment explained above, because component mounter 11 knows the characteristic rank of each die 22 by referring to the rank information (wafer map data) of each die 22 transmitted from die supply device 12, and knows the passive component 24 with the optimal characteristic to be combined with each die 22 by referring to the passive component combination data, component mounter 11 can select passive component 24 with the optimal characteristic to be combined with die 22 supplied from die supply device 12 from the multiple passive components (multiple feeders) with a different characteristic, and mount the passive component 24 on circuit board 17 such that variance in a characteristic of each die 22 is absorbed. Thus, the time-consuming work of ranking and taping is no longer necessary, and productivity is improved.

Note that, by referring to the wafer map, it is possible to select only dies with the same rank among each die on the wafer and supply only those dies to component mounter 11; however, dies of a different rank are arranged on the wafer in a random manner, and in order to select only dies with the same rank and supply only those dies to the component mounter, it is necessary to pick up dies which are scattered here and there on the wafer. However, when picking up dies which are scattered here and there on the wafer, the interval between the dies to be picked up becomes longer, which means that the influence of the positional deviation at which the dies are arranged becomes larger, making pickup easier to fail. In contrast, if supplying each die from the wafer to the mounter in the order in which the dies are arranged on the wafer as in the present embodiment, the influence of the positional deviation at which the dies are arranged becomes smaller, which enables the prevention of pickup failure.

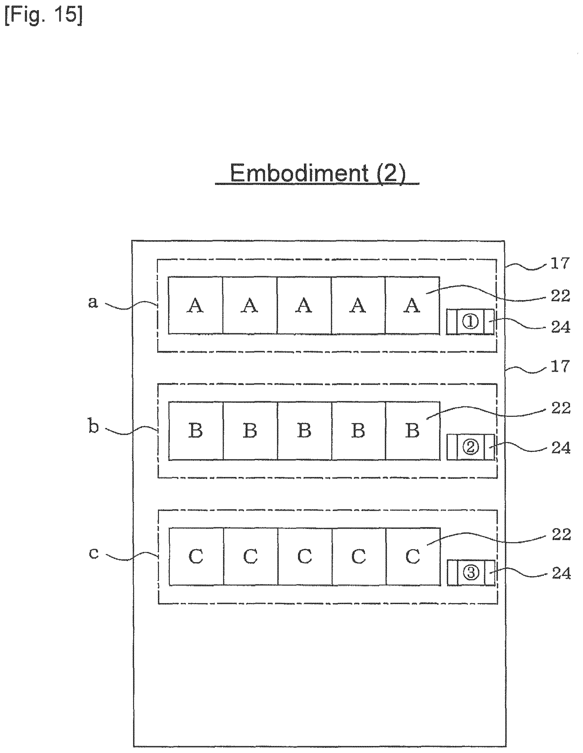

In the mounting example (1) of fig. 14, the variance in a characteristic of each die 22 is absorbed by combining each die 22 with one passive component 24 with the optimal characteristic for the respective die 22; however, in the mounting example (2) of fig. 15, in a case in which multiple dies 22 are mounted on one circuit board 17, the multiple dies 22 are classified into two or more groups, and dies 22 of the same rank are mounted in a line for each group, and for multiple dies 22 of the same rank belonging to each group, one passive component 24 is mounted in combination. In the example in fig. 15, dies 22 of the three types of ranks A, B, and C, are classified into groups a, b, and c; for group a, a passive component 24 supplied from feeder number 1 is mounted; for group b, a passive component 24 supplied from feeder number 2 is mounted; for group c, a passive component 24 supplied from feeder number 3 is mounted.

By doing this, the characteristic variance of dies 22 of each group can be reduced, for example, in a case in which the dies 22 are LEDs, the variance in LED brightness and hue due to variance in the characteristic of the LEDs of each group can be reduced, thus the brightness and hue of LEDs of each group can be made uniform.

Also, as in fig. 15, by mounting one passive component 24 in combination with respect to multiple dies 22 of the same rank belonging to a group, the quantity of passive components 24 mounted on circuit board 17 can be drastically reduced, thereby improving productivity and cost-effectiveness.

Note that, the present invention is not limited to the embodiment described above and it goes without saying that various embodiments with changes that do not extend beyond the scope of the invention are possible, such as that suitable changes may be made to the configuration of component mounter 11 or die supply device 12.

### Reference Signs List

11: component mounter; 12: die supply device; 13: feeder setting table; 15: mounting head; 16: XY moving mechanism; 17: circuit board; 22: die; 23: suction nozzle; 24: passive component; 25: conveyor; 26: component camera; 27: wafer pallet; 28: magazine; 29: dicing sheet; 32: stage; 33: supply head; 34: head moving mechanism; 35: drawing-out mechanism; 38: suction nozzle; 39: inverting mechanism; 40: head holding unit; 41: camera; 42: pushup mechanism

## Claims

1. A component mounting system comprising:
a component mounter (11) for mounting a die (22) on a circuit board (17) in combination with a passive component (24) with an appropriate characteristic for the die (22),
wherein the component mounter (11) is loaded with both a die supply device (12) that is configured to supply to be mounted dies (22) with variance in a characteristic, formed by dicing a wafer attached to a dicing sheet (29), and multiple feeders that are configured to supply the passive component (24) to be combined with the die (22); and
a means for acquiring wafer map data which ranks each die (22) of the wafer by the characteristic, and passive component combination data that specifies the passive component (24) with an appropriate characteristic for each rank of die (22) from multiple passive components (24) with a different characteristic;
wherein the component mounter (11) is configured to mount the die (22) and the passive component (24) on the circuit board (17),
wherein the multiple feeders are configured to supply the multiple passive components (24) with a different characteristic to the component mounter (11);
wherein the die supply device (12) is configured to supply each die (22) of the wafer sequentially to the component mounter (11); and
wherein the component mounter (11) is configured to mount the passive component (24) to be combined with the die (22) supplied from the die supply device (12) on the circuit board (17), by selecting the passive component (24) from the multiple passive components (24) with a different characteristic based on the wafer map data and the passive component combination data.

2. The component mounting system according to claim 1, wherein the component mounter (11), in a case in which multiple dies (22) are mounted on one circuit board (17), is configured to classify the multiple dies (22) into two or more groups, and is configured to mount dies (22) of the same rank in a line for each group.

3. The component mounting system according to claim 2, wherein the component mounter (11) is configured to mount one passive component (24) in combination with multiple dies (22) of the same rank belonging to each group.

4. The component mounting system according to any one of claims 1 to 3, wherein data indicating whether each die (22) on the wafer is good or defective is included in the wafer map data, and, based on the wafer map data, the die supply device (12) is configured to skip dies (22) which are determined to be defective and is configured to only supply dies (22) which are determined to be good to the component mounter (11).

5. The component mounting system according to any one of claims 1 to 4 provided with a data creation device that is configured to create the passive component combination data, wherein the data creation device is configured to transmit the created passive component combination data to the component mounter (11).

6. A component mounting method,
wherein a component mounter (11) for mounting a die (22) on a circuit board (17) in combination with a passive component (24) with an appropriate characteristic for the die (22) which is loaded with both a die supply device (12) that supplies to be mounted dies (22) with variance in a characteristic, formed by dicing a wafer attached to a dicing sheet (29) and multiple feeders that supply the passive component (24) to be combined with the die (22), mounts the die (22) and the passive component (24) on the circuit board (17) using the component mounter (11);
wherein wafer map data which ranks each die (22) of the wafer by the characteristic, and passive component combination data that specifies the passive component (24) with an appropriate characteristic for each rank of die (22) from multiple passive components (24) with a different characteristic, are acquired;
wherein the multiple feeders supply the multiple passive components (24) with a different characteristic to the component mounter (11);
wherein the die supply device (12) supplies each die (22) of the wafer sequentially to the component mounter (11); and
wherein the component mounter (11) mounts the passive component (24) to be combined with the die (22) supplied from the die supply device (12) on the circuit board (17), by selecting the passive component (24) from the multiple passive components (24) with a different characteristic based on the wafer map data and the passive component combination data.

## Patentansprüche

1. System zum Montieren von Bauteilen, das umfasst:
eine Bauteil-Montageeinrichtung (11) zum Montieren eines Chips (22) auf einer Leiterplatte (17) in Kombination mit einem passiven Bauteil (24) mit einer für den Chip (22) geeigneten Charakteristik,
wobei die Bauteil-Montageeinrichtung (11) sowohl mit einer Vorrichtung (12) zum Zuführen von Chips, die so eingerichtet ist, dass sie zu montierende Chips (22) mit Varianz hinsichtlich einer Charakteristik zuführt, die durch Sägen eines an einer Sägefolie (29) angebrachten Wafers ausgebildet werden, als auch mit mehreren Zuführeinrichtungen bestückt ist, die zum Zuführen des mit dem Chip (22) zu kombinierenden passiven Bauteils (24) eingerichtet sind; sowie
eine Einrichtung zum Erfassen von Daten zur Zuordnung von Wafern, nach denen jeder Chip (22) des Wafers entsprechend der Charakteristik eingestuft wird, sowie von Daten zur Kombination passiver Bauteile, die das passive Bauteil (24) mit einer geeigneten Charakteristik für jede Einstufung von Chips (22) unter mehreren passiven Bauteilen (24) mit einer anderen Charakteristik spezifizieren;
wobei die Bauteil-Montageeinrichtung (11) zum Montieren des Chips (22) und des passiven Bauteils (24) auf der Leiterplatte (17) eingerichtet ist,
die mehreren Zuführeinrichtungen zum Zuführen der mehreren passiven Bauteile (24) mit einer anderen Charakteristik zu der Bauteil-Montageeinrichtung (11) eingerichtet sind;
die Vorrichtung (12) zum Zuführen von Chips so eingerichtet ist, dass sie jeden Chip (22) des Wafers sequentiell der Bauteil-Montageeinrichtung (11) zuführt; und
die Bauteil-Montageeinrichtung (11) so eingerichtet ist, dass sie das mit dem von der Vorrichtung (12) zum Zuführen von Chips zugeführten Chip (22) zu kombinierende passive Bauteil (24) auf der Leiterplatte (17) montiert, indem sie das passive Bauteil (24) aus den mehreren passiven Bauteilen (24) mit einer anderen Charakteristik auf Basis der Daten zur Zuordnung von Wafern sowie der Daten zur Kombination passiver Bauteile auswählt.

2. System zum Montieren von Bauteilen nach Anspruch 1, wobei die Bauteil-Montageeinrichtung (11) so eingerichtet ist, dass sie, wenn mehrere Chips (22) auf einer Leiterplatte (17) montiert werden, die mehreren Chips (22) in zwei oder mehr Gruppen einteilt, und so eingerichtet ist, dass sie Chips (22) der gleichen Einstufung in einer Reihe für jede Gruppe montiert.

3. System zum Montieren von Bauteilen nach Anspruch 2, wobei die Bauteil-Montageeinrichtung (11) so eingerichtet ist, dass sie ein passives Bauteil (24) in Kombination mit mehreren Chips (22) der gleichen Einstufung montiert, die zu jeder Gruppe gehören.

4. System zum Montieren von Bauteilen nach einem der Ansprüche 1 bis 3, wobei Daten, die anzeigen, ob jeder Chip (22) auf dem Wafer fehlerfrei oder fehlerhaft ist, in den Daten zur Zuordnung von Wafern enthalten sind, und die Vorrichtung (12) zum Zuführen von Chips so eingerichtet ist, dass sie auf Basis der Daten zur Zuordnung von Wafern Chips (22) auslässt, die als fehlerhaft bestimmt werden und so eingerichtet ist, dass sie nur Chips (22), die als fehlerfrei bestimmt werden, der Bauteil-Montageeinrichtung (11) zuführt.

5. System zum Montieren von Bauteilen nach einem der Ansprüche 1 bis 4, das mit einer Vorrichtung zur Erzeugung von Daten versehen ist, die zum Erzeugen der Daten zur Kombination passiver Bauteile eingerichtet ist, wobei die Vorrichtung zur Erzeugung von Daten zum Übertragen der erzeugten Daten zur Kombination passiver Bauteile zu der Bauteil-Montageeinrichtung (11) eingerichtet ist.

6. Verfahren zum Montieren von Bauteilen,
bei dem eine Bauteil-Montageeinrichtung (11) zum Montieren eines Chips (22) auf einer Leiterplatte (17) in Kombination mit einem passiven Bauteil (24) mit einer für den Chip (22) geeigneten Charakteristik, die sowohl mit einer Vorrichtung (12) zum Zuführen von Chips, die zu montierende Chips (22) mit Varianz hinsichtlich einer Charakteristik zuführt, die durch Sägen eines an einer Sägefolie (29) angebrachten Wafers ausgebildet werden, als auch mit mehreren Zuführeinrichtungen bestückt ist, die das mit dem Chip (22) zu kombinierende passive Bauteil (24) zuführen, den Chip (22) und das passive Bauteil (24) unter Verwendung der Bauteil-Montageeinrichtung (11) auf der Leiterplatte (17) montiert;
wobei Daten zur Zuordnung von Wafern, nach denen jeder Chip (22) des Wafers entsprechend der Charakteristik eingestuft wird, sowie Daten zur Kombination passiver Bauteile erfasst werden, die das passive Bauteil (24) mit einer geeigneten Charakteristik für jede Einstufung von Chips (22) unter mehreren passiven Bauteilen (24) mit einer anderen Charakteristik spezifizieren;
die mehreren Zuführeinrichtungen die mehreren passiven Bauteile (24) mit einer anderen Charakteristik der Bauteil-Montageeinrichtung (11) zuführen;
die Vorrichtung (12) zum Zuführen von Chips jeden Chip (22) des Wafers sequentiell der Bauteil-Montageeinrichtung (11) zuführt; und
die Bauteil-Montageeinrichtung (12) das mit dem von der Vorrichtung (12) zum Zuführen von Chips zugeführten Chip (22) zu kombinierende passive Bauteil (24) auf der Leiterplatte (17) montiert, indem sie das passive Bauteil (24) aus den mehreren passiven Bauteilen (24) mit einer anderen Charakteristik auf Basis der Daten zur Zuordnung von Wafern sowie der Daten zur Kombination passiver Bauteile auswählt.

## Revendications

1. Système de montage de composants comprenant :
un monteur de composants (11) pour monter une matrice (22) sur une carte de circuits (17) en combinaison avec un composant passif (24) avec une caractéristique appropriée pour la matrice (22),
dans lequel le monteur de composants (11) est chargé à la fois d'un dispositif de fourniture de matrices (12) qui est configuré pour fournir des matrices à monter (22) présentant une variance dans une caractéristique, formées par une découpe en dés d'une galette fixée sur une feuille de découpe en dés (29), et de plusieurs dispositifs d'alimentation qui sont configurés pour fournir le composant passif (24) à combiner à la matrice (22) ; et
un moyen d'acquisition de données de carte de galette qui classent chaque matrice (22) de la galette par la caractéristique, et des données de combinaison de composant passif qui spécifient le composant passif (24) présentant une caractéristique approprié pour chaque classement de matrice (22) à partir de plusieurs composants passifs (24) avec une caractéristique distincte ;
dans lequel le monteur de composants (11) est configuré pour monter la matrice (22) et le composant passif (24) sur la carte de circuits (17),
dans lequel les plusieurs dispositifs d'alimentation sont configurés pour fournir les plusieurs composants passifs (24) présentant une caractéristique distincte au monteur de composants (11) ;
dans lequel le dispositif de fourniture de matrices (12) est configuré pour fournir chaque matrice (22) de la galette séquentiellement au monteur de composants (11) ; et
dans lequel le monteur de composants (11) est configuré pour monter le composant passif (24) à combiner à la matrice (22) fournie par le dispositif de fourniture de matrices (12) sur la carte de circuits (17), en sélectionnant le composant passif (24) à partir des plusieurs composants passifs (24) présentant une caractéristique distincte selon les données de carte de galette et les données de combinaison de composants passifs.

2. Le système de montage de composants selon la revendication 1, dans lequel le monteur de composants (11), dans un cas dans lequel plusieurs matrices (22) sont montées sur une carte de circuits (17), est configuré pour classifier les plusieurs matrices (22) en deux groupes ou plus, et est configuré pour monter des matrices (22) du même classement dans une ligne pour chaque groupe.

3. Le système de montage de composants selon la revendication 2, dans lequel le monteur de composants (11) est configuré pour monter un composant passif (24) en combinaison avec plusieurs matrices (22) du même classement appartement à chaque groupe.

4. Le système de montage de composants selon l'une quelconque des revendications 1 à 3, dans lequel des données indiquant si chaque matrice (22) sur la galette est intègre ou défectueuse sont incluses dans les données de carte de galette, et, selon les données de carte de galette, le dispositif de fourniture de matrice (12) est configuré pour ignorer des matrices (22) qui sont déterminées comme défectueuses et est configuré pour uniquement fournir des matrices (22) qui sont déterminées comme intègres au monteur de composants (11) .

5. Le système de montage de composant selon l'une quelconque des revendications 1 à 4 doté d'un dispositif de création de données qui est configuré pour créer les données de combinaison de composants passifs, dans lequel le dispositif de création de données est configuré pour transmettre les données de combinaison de composants passifs créées au monteur de composants (11).

6. Procédé de montage de composants,
dans lequel un monteur de composants (11) pour monter une matrice (22) sur une carte de circuits (17) en combinaison avec un composant passif (24) présentant une caractéristique appropriée pour la matrice (22) qui est chargé avec à la fois un dispositif de fourniture de matrices (12) qui fournit des matrices à monter (22) présentant une variance dans une caractéristique, formées par une découpe en dés d'une galette fixée sur une feuille de découpe en dés (29) et plusieurs dispositifs d'alimentation qui fournissent le composant passif (24) à combiner à la matrice (22), monte la matrice (22) et le composant passif (24) sur la carte de circuits (17) en utilisant le monteur de composants (11) ;
dans lequel des données de carte de galette qui classent chaque matrice (22) de la galette par la caractéristique, et des données de combinaison de composants passifs qui spécifient le composant passif (24) présentant une caractéristique appropriée pour chaque classement de matrice (22) à partir de plusieurs composants passifs (24) présentant une caractéristique distincte, sont acquises ;
dans lequel les plusieurs dispositifs d'alimentation fournissent les plusieurs composants passifs (24) présentant une caractéristique distincte au monteur de composants (11) ;
dans lequel le dispositif de fourniture de matrices (12) fournit chaque matrice (22) de la galette séquentiellement au monteur de composants (11) ; et
dans lequel le monteur de composants (11) monte le composant passif (24) à combiner à la matrice (22) fournie par le dispositif de fourniture de matrices (12) sur la carte de circuits (17), en sélectionnant le composant passif (24) à partir des plusieurs composants passifs (24) présentant une caractéristique distincte selon les données de carte de galette et les données de combinaison de composants passifs.
